Europäisches Patentamt

European Patent Office

Office européen des brevets

(11) Veröffentlichungsnummer: **0 428 987 A1**

## (12) EUROPÄISCHE PATENTANMELDUNG

(21) Anmeldenummer: 90121766.1

(22) Anmeldetag: 14.11.90

(51) Int. Cl.⁵: **H01R 17/12**

(30) Priorität: 18.11.89 DE 3938427

(43) Veröffentlichungstag der Anmeldung:
29.05.91 Patentblatt 91/22

(84) Benannte Vertragsstaaten:
**DE FR GB IT NL**

(71) Anmelder: **Standard Elektrik Lorenz
Aktiengesellschaft
Lorenzstrasse 10**
**W-7000 Stuttgart 40(DE)**

(72) Erfinder: **Rivoir, Peter
Friedensstrasse 3
W-7300 Esslingen a.N.(DE)**

(74) Vertreter: **Hösch, Günther, Dipl.-Ing. et al
Standard Elektrik Lorenz AG Patent- und
Lizenzwesen Postfach 30 09 29
W-7000 Stuttgart 30(DE)**

(54) **Prüfadapter.**

(57) Bei einem Prüfadapter zum Anschluß an ein nach der 4-Leiter-Meßmethode arbeitendes Meßgerät, der vier in Reihe liegende Koaxial-Steckerkupplungen (3, 4, 5, 6) aufweist, deren Wellenwiderstand an denjenigen des Meßgerätes angepaßt ist, werden die Leitungen (13 und 14) zur Stromversorgung und ggf. auch die Meßleitungen (16 und 17) als Streifenleitung (18) ausgebildet, deren Wellenwiderstand gleich oder annähernd gleich demjenigen der Koaxial-Steckerkupplungen (3, 4, 5, 6) ist. Dadurch werden Verfälschungen des Meßergebnisses durch Reflexionen auf der Meßstrecke vermieden. Außerdem können auf den Prüfadapter einwirkende Störfelder das Meßergebnis nicht oder kaum beeinflussen.

Fig. 2

EP 0 428 987 A1

# PRÜFADAPTER

Die Erfindung bezieht sich auf einen Prüfadapter gemäß dem Oberbegriff des Anspruchs 1.

Derartige Prüfadapter werden von Herstellern von nach der 4-Leiter-Meßmethode arbeitenden Meßgeräten und auch von Zulieferern angeboten. So ist es bekannt, die Kontaktstellen der Meßstrecke als federnde Kontaktklemmen auszubilden. Diese sind jeweils über einen Draht mit dem Innenleiter der zugeordneten Koaxial-Steckerkupplung verbunden. An den Übergängen zwischen der Steckerkupplung und dem Draht sowie dem Draht und der Kontaktstelle treten sprunghafte Änderungen der Wellenwiderstände der Leitungen auf, die zu unerwünschten, das Meßergebnis verfälschenden Reflexionen führen. Außerdem kann ein in die Nähe des Prüfadapters gelangendes Potential, z.B. die Hand der Bedienungsperson, das Feld im Bereich des Prüfadapters derart stören, daß das Meßergebnis beeinflußt wird.

Mit der vorliegenden Erfindung soll die Aufgabe gelöst werden, einen Prüfadapter der eingangs genannten Art derart auszubilden, daß Reflexionen entlang der Leitungsführung des Prüfadapters und Störungen der entstehenden Feldverteilung vermieden werden.

Gelöst wird diese Aufgabe durch die im Kennzeichen des Anspruchs 1 angegebenen Merkmale. Durch die Streifenleitung mit dem angepaßten Wellenwiderstand treten praktisch keine sprunghaften Änderungen der Wellenwiderstände an den Verbindungsstellen auf, so daß Reflexionen nicht mehr oder nur in vernachlässigbarer Größenordnung auftreten. Außerdem ist das im Bereich der Streifenleitung entstehende elektromagnetische Feld auf einen sehr kleinen Raum begrenzt, so daß eine Beeinflussung von außen her nicht mehr auftritt.

Weitere vorteilhafte Einzelheiten der Erfindung sind in den Unteransprüchen angegeben und nachfolgend anhand der in der Zeichnung veranschaulichten Ausführungsbeispiele beschrieben. Es zeigen:

Fig. 1 eine Ansicht auf die den herausgeführten Koaxial-Steckerkupplungen gegenüberliegende Seite des Prüfadapters,

Fig. 2 eine Draufsicht auf den Prüfadapter der Fig. 1,

Fig. 3 die Ansicht auf die in der Zeichnung in Fig. 1 und 2 linke Stirnseite des Prüfadapters,

Fig. 4 eine mögliche Ausführungsform als einfache Streifenleitung in einer Draufsicht,

Fig. 5 eine Ausführungsform als symmetrische Streifenleitung in einer Draufsicht und

Fig. 6 eine Ansicht gemäß dem Schnitt I-I der Fig. 5.

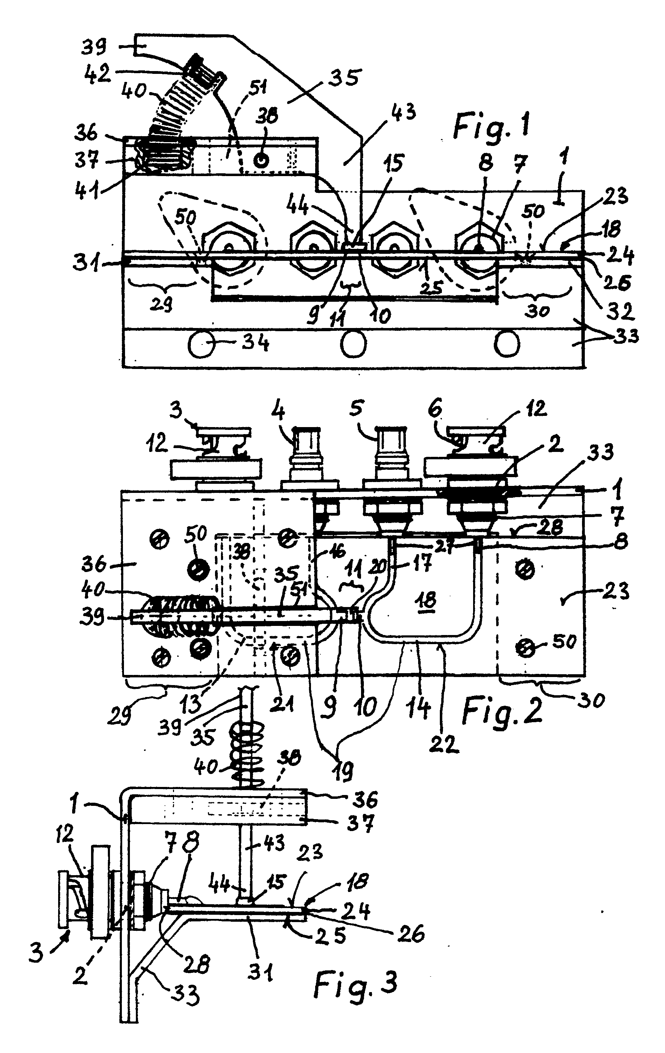

Mit 1 ist in den Figuren 1 bis 3 ein vorzugsweise aus Metall bestehender Träger eines Prüfadapters für ein nach der 4-Leiter-Meßmethode arbeitendes Meßgerät bezeichnet, der mit vier in einer Reihe liegenden Bohrungen 2 versehen ist. In diese sind Koaxial-Steckerkupplungen 3, 4, 5 und 6, z.B. in Form von BNC-Einbausteckern, eingesetzt und mit dem Träger 1 in an sich bekannter weise durch je eine Verschraubung 7 befestigt. Der Träger 1 dient zugleich für alle Koaxial-Steckerkupplungen 3 bis 6 als gemeinsame Potentialschiene, die in der Regel auf Masse gelegt wird. Die Koaxial-Steckerkupplungen 3 bis 6 besitzen einen Wellenwiderstand, der an denjenigen des Meßgerätes, an das der Prüfadapter angeschlossen werden soll, angepaßt ist. Beispielsweise beträgt der Wellenwiderstand 50 Ohm, wenn derjenige oder der Innen-oder Quellenwiderstand des Meßgeräts 50 Ohm oder etwa 50 Ohm beträgt.

Die aus der Verschraubung 7 der Koaxial-Steckerkupplungen 3 bis 6 herausragenden Innenleiterabschnitte 8 derselben sind entsprechend der 4-Leiter-Meßmethode mit Kontaktstellen 9 und 10 einer Meßstrecke 11 verbunden, nämlich: Die beiden äußeren, z.B. jeweils mit einem Bajonettverschluß 12 versehenen Koaxial-Steckerkupplungen 3 und 6 sind über je eine Leitung 13 bzw. 14 mit der Kontaktstelle 9 bzw. 10 verbunden. Die Meßstrecke 11 wird durch ein einzusetzendes, zu messendes elektrisches Bauelement 15 oder Netzwerk überbrückt und diesem über die Koaxial-Steckerkupplungen 3 und 6 ein Meßstrom eingeprägt. Die eine innere Koaxial-Steckerkupplung 4 ist über eine Meßleitung 16 mit der Kontaktstelle 9 und die andere innere Koaxial-Steckerkupplung 5 ist über eine Meßleitung 17 mit der Kontaktstelle 10 verbunden. über diese beiden Meßleitungen 16, 17 und Koaxial-Steckerkupplungen 4, 5 kann die am Bauelement 15 infolge des Meßstromes anstehende Spannung gemessen werden.

Erfindungsgemäß sind die Leitungen 13 und 14 als Streifenleitung 18 ausgebildet, die einen Wellenwiderstand aufweist, der demjenigen der Koaxial-Steckerbuchsen 3 und 6 entspricht. Im oben gewählten Fall von 50 Ohm beträgt der Wellenwiderstand der Streifenleitung ebenfalls 50 Ohm oder wenigstens annähernd 50 Ohm. Die Leitungen 13 und 14 bilden dabei den Innenleiter 19, der an einer Trennstelle 20 durchgetrennt ist, wodurch die Meßstrecke 11 gebildet ist. Die Kontaktstellen 9 und 10 werden dabei von den dort endenden Teilstücken 21 bzw. 22 des Innenleiters 19 gebildet.

Der vergoldete Innenleiter 19 und die Meßleitungen 16 und 17 sind auf der einen Seite 23 einer di-elektrisch wirksamen Isolierstoffplatte 24 z.B. nach Art einer gedruckten Schaltung hergestellt.

Auf der anderen Seite 25 derselben ist der sich vorteilhaft über die gesamte Fläche dieser Seite 25 der Isolierstoffplatte 24 erstreckende Außenleiter 26 in Form einer z.B. aufkaschierten z.B. vergoldeten Kupferfolie aufgebracht.

Um einen günstigen möglichst sprungfreien Übergang zwischen den Koaxial-Steckerkupplungen 3 bis 6 und dem Innenleiter 19 bzw. den Meßleitungen 16 und 17 zu erhalten, sind deren Anschlußstellen 27 zu der den Verschraubungen 7 benachbarten Kante 28 der Isolierstoffplatte 24 geführt und dort mit dem zugeordneten Innenleiterabschnitt 8 der Koaxial-Steckerkupplungen 3 bis 6 verlötet und/oder gebonded.

Die Streifenleitung 18 liegt mit Abschnitten 29 und 30, die die seitlichen Endbereiche der Isolierstoffplatte 24 bilden, über den bis in diese Abschnitte 29, 30 reichenden Außenleiter 26 auf je einer am Trager 1 befestigten Kontaktplatte 31 bzw. 32 auf und ist mit dieser fest und elektrisch leitend verbunden. Die Kontaktplatten 31, 32 sind vorteilhaft so angeordnet, daß sie nicht in den Wirkungsbereich der Streifenleitung 18 bzw. des Innenleiters 19 derselben reichen. Die Kontaktplatten 31, 32 können ein Teil des Trägers 1 sein und durch entsprechende Abwinkelung gebildet werden. Beim Ausführungsbeispiel sind sie Teil einer Winkelschiene 33, die mit dem Träger 1 fest und elektrisch leitend verbunden, z.B. verschweißt sind, wie durch die Schweißrondellen 34 angedeutet. .

Gemäß einer vorteilhaften Ausgestaltung der Erfindung können auch die Meßleitungen 16 und 17 als Streifenleitungen mit einem an die Koaxial-Steckerkupplungen 4 bzw. 5 angepaßten Wellenwiderstand ausgebildet ein.

Zwecks einfacher Einsetzbarkeit und zur guten Kontaktierung des Bauelements 15 oder eines Netzwerks ist oberhalb der Trennstelle 20 ein z.B. in Form eines Schwenkhebels 35 ausgebildetes Druckelement vorgesehen, das an einer im Abstand über die Streifenleitung 18 ragende Lasche 36 des Trägers 1 oder, wie beim Ausführungsbeispiel, in einem an der Lasche 36 z.B. angeschraubten Haltekörper 37 aus vorzugsweise elektrisch isolierendem Material um eine Schwenkachse 38 schwenkbar gelagert ist. Die Lasche 36 oder der Haltekörper 37 soll die Meßstrecke 11 nicht überdecken. Zwischen dem seitlich nach oben ragenden Arm 39 und der Lasche 36 oder dem Haltekörper 37 ist eine Druckfeder 40 eingespannt. Zur Lagefixierung der als Spiralfeder ausgebildeten Druckfeder 40 ist beispielsweise in der Lasche 36 oder dem Haltekörper 37 ein Sackloch 41 und am Arm 39 ein Führungssteg 42 vorgesehen. Ein im Haltekörper 37 und der Lasche 36 angebrachter Schlitz 51 dient zur Führung des Schwenkhebels 35.

Durch die Druckfeder 40 wird der Schwenkhebel 35 um die Schwenkachse 38 im Uhrzeigesinn vorgespannt, wodurch der nach unten gegen die Trennstelle 20 bzw. das dort befindliche Bauelement 15 bewegbare Arm 43 mit einem stiftförmigen Endteil 44 das eingesetzte Bauelement 15 mit dessen Anschlüssen gegen die Kontaktstellen 9, 10 drücken kann.

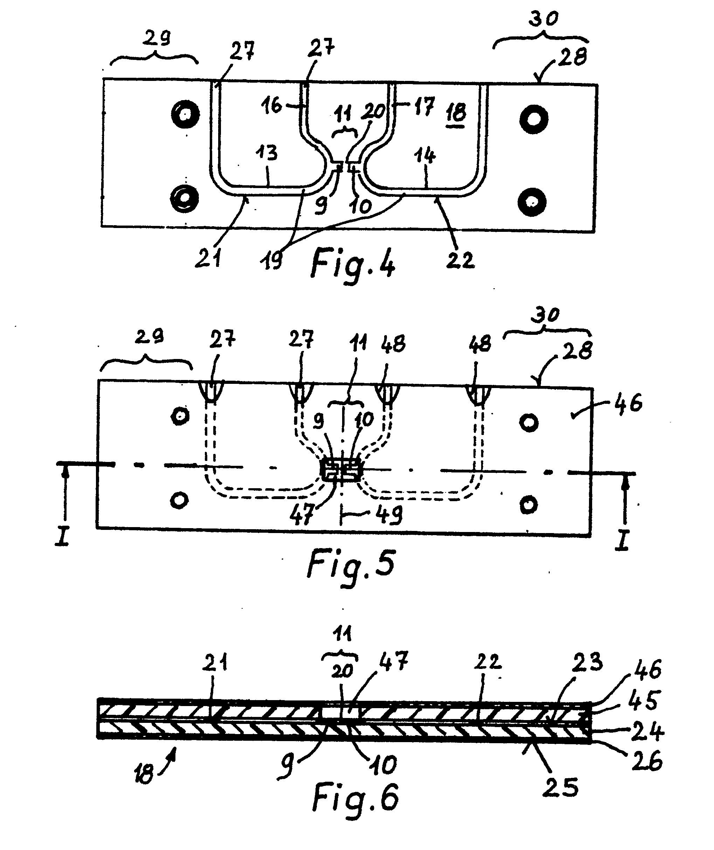

Die Streifenleitung 18 und gegebenenfalls die ebenfalls als Streifenleitungen ausgeführten Meßleitungen 16, 17 können, wie in den Figuren 1 bis 4 dargestellt, als einfache Streifenleitungen ausgebildet sein. Um z.B. eine noch bessere Abschirmung und Güte zu erreichen, können diese vorteilhaft als symmetrische Streifenleitung ausgebildet sein, wie anhand der Figuren 5 und 6 beispielhaft dargestellt. Diese besteht, wie anhand der Fig. 6 ersichtlich, z.B. aus einer einfachen Streifenleitung 18 wie vorher beschrieben, also aus einer Isolierstoffplatte 24 mit dem sich über die ganze Seite 25 erstreckenden Außenleiter 26 und dem Innenleiter 19. über dieser ist eine zweite Isolierstoffplatte 45 angeordnet, die mit einem Außenleiter 46 versehen ist. Die Isolierstoffplatte 45 ist mit einem geeigneten Kleber z.B. auf Epoxydharzbasis oder einem anderen, gute dielektrische Eigenschaften aufweisenden Kleber mit der Streifen Leitung 18 verbunden. Der Außenleiter 46 ist in geeigneter Weise, z.B. durch die zur Befestigung dienenden Schrauben 50 über die Kontaktpatten 31, 32, mit der Potentialschiene 1 oder dem gleichen Potential verbunden.

Oberhalb der Trennstelle 20 besitzt die Isolierstoffplatte 45 im Bereich der Meßstrecke 11 eine Aussparung 47. In diese kann ein Bauelemnt 15 zwecks Kontaktierung mit den Kontaktstellen 9, 10 des Innenleiters 19 und zur Durchführung des Meßvorgangs eingesetzt werden.

In diese kann ein Bauelement 15 zwecks Kontaktierung mit den Kontaktstellen 9, 10 des Innenleiters 19 und zur Durchführung des Meßvorgangs eingesetzt werden.

Außerdem ist die Isolierstoffplatte 45 derart ausgebildet, daß die Anschlußstellen 27 des Innenleiters 19 und der Meßeitungen 16, 17 kontaktierbar sind. Beim Ausführungsbeispiel sind hierfür in der Isolierstoffplatte 45 zungenförmige Ausschnitte 48 vorgesehen (Fig. 5). Vorzugsweise sind die Ausschnitte 48 derart ausgebildet, daß dort kein Wellenwiderstandssprung auftritt. Dies kann z.B. durch keil- oder parabel- oder ellipsenförmige Gestaltung der Ausschnitte 48 oder Ausbildung des Außenleiters 46 in diesen Bereichen erreicht werden.

Gemäß einer weiteren vorteilhaften Ausgestaltung der Erfindung ist die Trennstelle 20 in der Mitte oder annähernd in der Mitte des Innenleiters 19 vorgesehen und teilt diesen in gleiche Abschnitte 21, 22, die vorzugsweise noch spiegelbildlich zur Trennlinie 49 der Trennstelle 20 ausgebildet sein können, wie die Ausführungsbeispiele zeigen.

Der Prüfadapter gemäß der Erfindung ist besonders geeignet zur Messung von in SMD-Technik hergestellten Bauelementen. Insbesondere können in SMD-Technik hergestellte Spulen mit kleinen Induktivitäten mit hoher Genauigkeit gemessen werden, da die Streifenleitung eine sehr geringe Eigeninduktivität besitzt.

Bezugszeichenliste

1 Träger
2 Bohrung in 1
3 Koaxial-Steckerkupplung
4 Koaxial-Steckerkupplung
5 Koaxial-Steckerkupplung
6 Koaxial-Steckerkupplung
7 Verschraubung v. 3-6
8 Innenleiterabschnitt v. 3-6
9 Kontaktstelle
10 Kontaktstelle
11 Meßstrecke
12 Bajonettverschluß
13 Leitung 3-9
14 Leitung 6-10
15 Bauelement
16 Meßleitung 4-9
17 Meßleitung 5-10
18 Steifenleitung
19 Innenleiter v. 18
20 Trennstelle v. 19
21 Abschnitt v. 19
22 Abschnitt v. 29
23 Seite der Isolierstoffplatte 24
24 Isolierstoffplatte
25 Seite v. 24
26 Außenleiter
27 Anschlußstellen v. 19, 16, 17
28 Kante v. 24
29 Abschnitt v. 24
30 Abschnitt v. 24
31 Kontaktpatte
32 Kontaktpatte
33 Winkelschiene
34 Schweißrondelle
35 Schwenkhebel
36 Lasche
37 Haltekörper
38 Schwenkachse v. 35
39 Arm v. 35
40 Druckfeder
41 Sackloch
42 Führungssteg
43 Arm v. 35
44 Endteil v. 43
45 Isolierstoffplatte
46 Außenleiter v. 45
47 Aussparung v. 45
48 Ausschnitte v. 45
49 Trennlinie v. 20
50 Schrauben

## Ansprüche

1. Prüfadapter zum Anschluß an ein nach der 4-Leiter-Meßmethode arbeitendes Meßgerät zum Messen der elektrischen Werte eines elektrischen Bauelements oder Netzwerks, mit vier in einer Reihe liegenden und an einen gemeinsamen Träger in gleicher Richtung angeordneten Koaxial-Steckerkupplungen, deren Wellenwiderstand an denjenigen des Meßgerätes angepaßt ist, wobei der Innenleiter der beiden äußeren Koaxial-Steckerkupplungen über je eine Leitung mit je einer Kontaktstelle einer Meßstrecke verbunden ist, über die ein zu messendes Bauteil mit einem Meßstrom versorgt werden kann und über die beiden inneren Koaxial-Steckerkupplungen, die jeweils über eine Meßleitung mit je einer Kontaktstelle der Meßstrecke verbunden sind, die am zu messenden Bauelement durch den Meßstrom anstehende Spannung abgreifbar ist, **dadurch gekennzeichnet,** daß die Leitungen (13, 14) zwischen den äußeren Koaxial-Steckerkupplungen (3, 6) als Streifenleitung ausgebildet sind, deren Wellenwiderstand gleich oder annähernd gleich demjenigen der zugeordneten Koaxial-Steckerkupplungen (3, 6) ist und deren Innenleiter (19) zur Bildung der Meßstrecke (11) eine Trennstelle (20) aufweist.

2. Prüfadapter nach Anspruch 1, dadurch gekennzeichnet, daß die Meßeitungen (16, 17) als Streifenleitungen ausgebildet sind, deren Wellenwiderstand gleich oder annähernd gleich demjenigen der zugeordneten Koaxial-Steckerkupplungen (4 bzw. 5) ist.

3. Prüfadapter nach Anspruch 1 oder 2, dadurch gekennzeichnet, daß die im Bereich der Meßstrekke (11) endenden Abschnitte (21, 22) des Innenleiters (19) als Kontaktstelle (9 bzw. 10) dienen bzw. ausgebildet sind.

4. Prüfadapter nach Anspruch 1, 2 oder 3, dadurch gekennzeichnet, daß über der Trennstelle (20) ein Druckelement (35) vorgesehen ist, das unter Vorspannung einer Feder (40) ein zwischen dem Druckelement (35) und der Trennstelle (20) einsetzbares Bauelement (15) mit seinen Anschlüssen gegen die Kontaktstellen (9, 10) drücken kann.

5. Prüfadapter nach einem der Ansprüche 1 bis 4, dadurch gekennzeichnet, daß die Anschlußstellen (27) des Innenleiters (19) und der Meßleitungen (16, 17) nach einer Kante (28) eines mit der Streifenleitung (18) versehenen Trägers (24) geführt sind und mit dem Innenleiterabschnitt (8) der jeweils zugeordneten Koaxial-Steckerkupplung (3 bis 6) verlötet sind.

6. Prüfadapter nach einem der Ansprüche 1 bis 5, dadurch gekennzeichnet, daß die Koaxial-Steckerkupplungen (3 bis 6) über ihre Verschraubung (7) mit einer gemeinsamen Potentialschiene (Träger 1) elektrisch leitend verbunden sind und die Potentialschiene (1) außerhalb des Wirkungsbereichs der Streifenleitung (18) mit wenigstens einem sich über diesen Wirkungsbereich hinaus erstreckenden Abschnitt (29 bzw. 30) des Außenleiters (26) der Streifenleitung (18) elektrisch leitend verbunden ist.

7. Prüfadapter nach Anspruch 6, dadurch gekennzeichnet, daß sich die Abschnitte (29, 30) seitlich über die äußeren Koaxial-Steckerkuppungen (3 und 6) nach außen erstrecken und auf in den Bereich der Abschnitte (29, 30) reichenden Kontaktplatten (31, 32) der Potentialschiene (1) aufliegen und mit diesen fest und elektrisch leitend verbunden sind.

8. Prüfadapter nach einem der Ansprüche 1 bis 7, dadurch gekennzeichnet, daß die Streifenleitung als einfache Streifenleitung ausgebildet ist.

9. Prüfadapter nach einem der Ansprüche 1 bis 7, dadurch gekennzeichnet, daß die Streifenleitungen als symmetrische Streifenleitung (Triplate-Leitung) ausgebildet ist bzw. sind, deren eine Seite (45) im Bereich der Meßstrecke (11) eine Aussparung (47) aufweist, in die ein Bauelement (15) einsetzbar und mit deren Kontaktstellen (9, 10) kontaktierbar ist und die so ausgebildet ist bzw. sind, daß die Anschlußstellen (27) des Innenleiters (19) und der Meßleitungen (16, 17) kontaktierbar, insbesondere mit den Innenleiterabschnitten (8) der zugeordneten Koaxial-Steckerkupplung verlötbar sind, und daß beide Außenleiter (26, 46) mit der Potentialschiene (1) elektrisch leitend verbunden sind.

10. Prüfadapter nach einem der Ansprüche 1 bis 9, dadurch gekennzeichnet, daß der gemeinsame Träger (1) die Potentialschiene bildet.

11. Prüfadapter nach einem der Ansprüche 1 bis 10, dadurch gekennzeichnet, daß am Trager (1) eine mit Abstand über die Streifenleitung(en) (18) ragende, sich jedoch nicht über die Meßstrecke (11) erstreckende Lasche (36) vorgesehen ist, an der das Druckelement unmittelbar oder über einen Haltekörper (37) gelagert ist.

12. Prüfadapter nach Anspruch 11, dadurch gekennzeichnet, daß das Druckelement als federbelasteter Schwenkhebel (35) ausgebildet ist.

13. Prüfadapter nach Anspruch 12, dadurch gekennzeichnet, daß der eine Arm (43) des Schwenkhebels (35) mit einem stiftförmigen Endteil (44) gegen den Bereich der Trennstelle (20) federt und zwischen dem anderen Arm (39) und der Lasche (36) eine die Vorspannung erzeugende Feder (40) eingespannt ist.

14. Prüfadapter nach einem der Ansprüche 1 bis 13, dadurch gekennzeichnet, daß die Trennstelle (20) in der Mitte des Innenleiters (19) vorgesehen ist.

15. Prüfadapter nach einem der Ansprüche 1 bis 14, dadurch gekennzeichnet, daß die Innenleiterabschnitte (21, 22) bezüglich der Trennstelle spiegelbildlich ausgebildet sind.

16. Prüfadapter nach einem der Ansprüche 1 bis 15, dadurch gekennzeichnet7 daß zumindest die Kontaktstellen (9, 10) der Streifenleitung (18) ver-goldet sind.

Fig.1

Fig.2

Fig.3

Fig.4

Fig.5

Fig.6

<table>
<tr><td colspan="2" align="center"><strong>Europäisches Patentamt</strong></td><td align="center"><strong>EUROPÄISCHER RECHERCHENBERICHT</strong></td><td>Nummer der Anmeldung<br><strong>EP 90 12 1766</strong></td></tr>
</table>

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | US-A-3 662 318 (DECUYPER)<br>* Spalte 2, Zeilen 53 - 55 * * Spalte 2, Zeile 71 - Spalte 3, Zeile 6; Figuren 2-3 * | 1-10, 14-15 | H 01 R<br>17/12 |
| | – – – | | |
| Y,A | DE-A-3 134 801 (BOSCH)<br>* Seite 4, Absatz 1 * * Seite 6, Absatz 1; Figur 2 * | 1-10, 14-15, 11-13 | |
| | – – – | | |
| A | IBM Technical Disclosure Bulletin vol. 8, no. 8, Januar 1966, Seite 1059 E.C.Uberbacher, R.Short: "Crossover connector"<br>* das ganze Dokument * | 1-2,8-9 | |
| | – – – – – | | |

**RECHERCHIERTE SACHGEBIETE (Int. Cl.5)**

H 01 R
G 01 R

Der vorliegende Recherchenbericht wurde für alle Patentansprüche erstellt

| Recherchenort | Abschlußdatum der Recherche | Prüfer |
|---|---|---|
| Den Haag | 04 Februar 91 | SIBILLA S.E. |